**Europäisches Patentamt**

**European Patent Office**

**Office européen des brevets**

(11) Veröffentlichungsnummer: **0 325 173**
**A2**

## EUROPÄISCHE PATENTANMELDUNG

(21) Anmeldenummer: **89100559.7**

(51) Int. Cl.⁴: **G01R 25/00**

(22) Anmeldetag: **13.01.89**

(30) Priorität: **16.01.88 DE 3801154**

(43) Veröffentlichungstag der Anmeldung:
**26.07.89 Patentblatt 89/30**

(84) Benannte Vertragsstaaten:
**AT BE CH DE ES FR GB GR IT LI LU NL SE**

(71) Anmelder: **Deutsches
Elektronen-Synchrotron DESY
Notkestrasse 85
D-2000 Hamburg 52(DE)**

(72) Erfinder: **Peters, Jens
Saturnweg 13
D-2000 Hamburg 65(DE)**
Erfinder: **Becker, Ludwig
Baron-Voght-Strasse 21
D-2000 Hamburg 52(DE)**

(74) Vertreter: **UEXKÜLL & STOLBERG
Patentanwälte
Beselerstrasse 4
D-2000 Hamburg 52(DE)**

(54) **Messsschaltung zur Phasenmessung gepulster Hochfrequenzsignale.**

(57) Eine Meßschaltung zur Phasenmessung gepulster Hochfrequenz-Signale besitzt einen Phasendetektor (2), der einen Meßsignaleingang (1) und einen Referenzsignaleingang (3) aufweist und der aus der Phasendifferenz zwischen Meßsignal und Referenzsignal ein Phasendifferenzsignal erzeugt, das einer Sample & Hold-Schaltung (4) zugeführt wird, die daraus eine Gleichspannung erzeugt. Die Gleichspannung wird einem Phasenkorrekturspeicher (8) eingegeben, in dem eine Korrektur der Nichtlinearität des Phasendetektors erfolgt. An den Meßsignaleingang (i) und den Referenzsignaleingang (3) ist eine Amplitudengewinnungsschaltung (6) angeschlossen, die die Amplitude des Meßsignals und des Referenzsignals ermittelt. An den Ausgang der Amplitudengewinnungsschaltung (6) ist ein Amplitudenkompressionsspeicher (10) angeschlossen, der eine mit der Signalamplitude steuerbare Dichte der Kennlinienkorrekturen vornimmt. Die Ausgänge der Sample & Hold-Schaltung (4) und der Amplitudenkompressionsschaltung (10) steuern den Phasenkorrekturspeicher (8), der die Verzerrung der Phasenkennlinie korrigiert.

Fig.1

## Meßschaltung zur Phasenmessung gepulster Hochfrequenzsignale

Die Erfindung betrifft eine Meßschaltung gemäß Oberbegriff des Patentanspruchs 1.

Eine Meßschaltung zur Messung der Phase gepulster Hochfrequenz-Signale ist beispielsweise aus der SLAC-Publikation SLAC-PUB-2902 vom April 1982 bekannt. Derartige Schaltungen werden u.a. zur Überwachung von Radaranlagen sowie der gepulsten Hochfrequenzsignale von Linearbeschleunigern und Synchrotronen in der Hochenergiephysik eingesetzt. Die bekannte Meßschaltung verwendet Phasenschieber und Mischer sowie einen Signalprozessor und ist deshalb aufwendig und vom Temperaturverhalten sowohl des eingesetzten Mischers, als auch des Phasenschiebers abhängig.

Es ist ferner bereits bekannt, die Phasenmessung mit einem Oszillographen vorzunehmen, dies führt dann allerdings zu Schwierigkeiten, wenn das Signal auf digitaler oder analoger Basis weiterverarbeitet wird. Eine derartige Schaltung wird von der Firma Aertech hergestellt. Sie bezeichnet ihre Phasendetektorschaltung als "Polar Phase Discriminator".

Es ist **Aufgabe** der Erfindung, eine Meßschaltung zur Phasenmessung gepulster Hochfrequenzsignale zu schaffen, bei der das aufwendige Abstimmen der HF-Bauteile aufeinander wie beispielsweise das Aussuchen von Diodenpaaren entfallen kann.

Zur **Lösung** dieser Aufgabe dienen die kennzeichnenden Merkmale des Patentanspruchs 1 in Verbindung mit dessen Oberbegriff.

Gemäß Erfindung tritt also an die Stelle der aufwendigen Abstimmung der HF-Bauteile aufeinander die Vermessung des Phasendetektors und eine mit einem Computer ermittelte Programmierung von Speichern, über die mehrdimensionale Korrekturen errechnet und gespeichert werden. Die hierdurch erreichbaren Genauigkeiten sind praktisch nur durch den Aufwand an digitalen Speichern und den Digitalisierungsfehler begrenzt.

Die erfindungsgemäße Begrenzung der phasenempfindlichen Hochfrequenzbauteile auf den Phasendetektor macht es möglich, diese Schaltung in einem Ofen unterzubringen und dadurch auch in der Temperatur zu stabilisieren.

Durch die erfindungsgemäße Verwendung eines Amplitudenkompressionsspeichers kann ferner der eingesetzte Phasenkorrekturspeicher optimal genutzt werden, indem in Amplitudenbereichen mit stärkerer Phasenverzerrung die Korrekturkennlinien im Phasenkorrekturspeicher häufiger gewechselt werden. Damit sind Meßgenauigkeiten im 1/1o Grad-Bereich für Phasenmessungen zu erreichen.

Die Erfindung ist auch für die Phasenmessung zwischen gepulsten und ungepulsten sowie nur zwischen ungepulsten Hochfrequenzsignalen einsetzbar.

Vorteilhafte Ausgestaltung der Erfindung ergeben sich aus den Unteransprüchen.

Die Erfindung wird im folgenden anhand von Figuren näher erläutert; es zeigen:

Figur 1 ein Blockschaltbild eines ersten Ausführungsbeispiels;

Figur 2 ein zweites Ausführungsbeispiel; und

Figur 3 Einzelheiten der in Figur 2 dargestellten Amplitudengewinnungsschaltung.

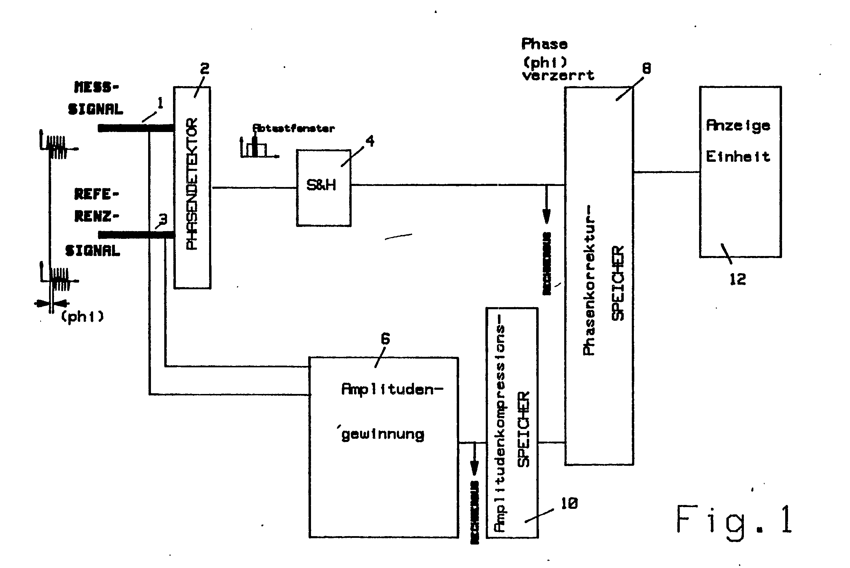

Figur 1 zeigt ein erstes Ausführungsbeispiel mit einem Phasendetektor 2, der einen Meßsignaleingang 1 und einen Referenzsignaleingang 3 aufweist. Dabei ist das Meßsignal gegenüber dem Referenzsignal um den Phasenwinkel (phi) verschoben.

Der Phasendetektor 2 ermittelt die Phasendifferenz (phi) auf irgendeine bekannte Weise, beispielsweise mit Hilfe von an sich bekannten Mischerschaltungen und gibt ein Phasendifferenzsignal (phi) als gepulste Gleichspannung an eine Sample & Hold-Schaltung 4 aus. Die Sample & Hold-Schaltung 4 ist ebenfalls an sich bekannt; sie ist in der Lage, ein Abtastfenster über den vom Phasendetektor 2 ausgegebenen Gleichspannungsimpuls zu legen und dabei den Gleichspannungspegel der Phasendifferenz (phi) an einen Phasenkorrekturspeicher 8 auszugeben. Der Phasenkorrekturspeicher 8 nimmt die Phase (phi) von der Sample & Hold-Schaltung 4 verzerrt auf und korrigiert sie in weiter unten zu erläuternder Weise.

Parallel dazu werden das Meßsignal und das Referenzsignal von dem Meßsignaleingang 1 und dem Referenzsignaleingang 3 abgenommen und einer Amplitudengewinnungsschaltung 6 zugeführt, welche die gerade gemessene Signalamplitude auf irgendeine bekannte Weise feststellt und ein entsprechendes Signal an einen Amplitudenkompressionsspeicher 10 ausgibt. Im Amplitudenkompressionsspeicher 10 ist ein Amplitudenkennlinienfeld gespeichert; durch das jeweilige Signal von der Amplitudengewinnungsschaltung 6 wird eine der im Amplitudenkompressionsspeicher 10 gespeicherten Kennlinien ausgewählt. Da die Ausgaben des Amplitudenkompressionsspeichers 10 über einen Eingang des Phasenkorrekturspeichers 8 in diesen Speicher eingegeben werden, ist es möglich, je nach ausgewählter Amplitudenkennlinie die Korrekturkennlinien für die Phasenverzerrung mehr oder weniger schnell zu wechseln. Auf diese Weise kann die dem Phasenkorrekturspeicher 8 eingegebene verzerrte Phase (phi) entzerrt und mit einer Anzeigeeinheit 12, die dem Phasenkorrekturspeicher 8 nachgeschaltet ist, angezeigt werden.

Es wird darauf hingewiesen, daß die Signale am Eingang der beiden Speicher 8 und 10 abgenommen und zweckmäßigerweise einem Computer über einen Rechnerbus eingegeben werden können. Die beiden Speicher 8 und 10 sind beispielsweise an sich bekannte EPROMs.

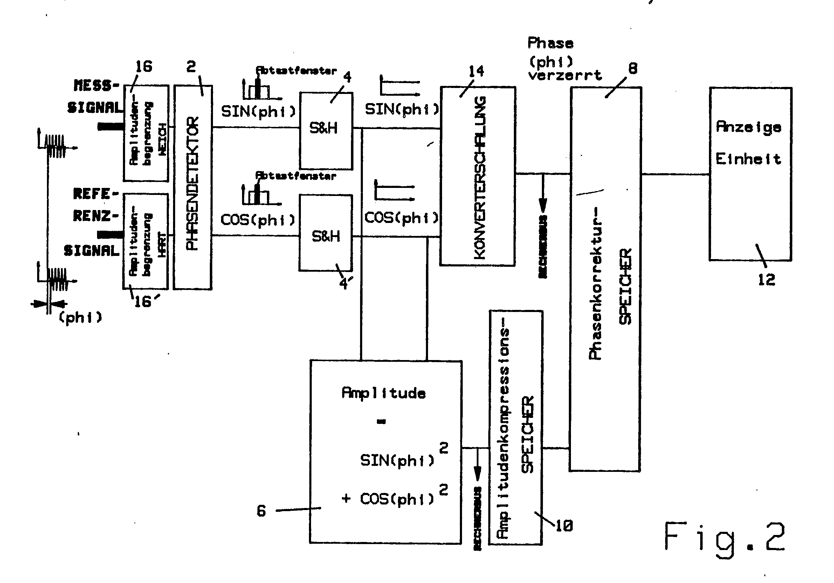

Figur 2 zeigt ein zweites Ausführungsbeispiel, bei dem gleiche Teile mit gleichen Bezugszeichen versehen sind. Dem Phasendetektor 2 des zweiten Ausführungsbeispiels sind Amplitudenbegrenzungsschaltungen 16 und 16' vorgeschaltet, die eine weiche und eine harte Amplitudenbegrenzung vornehmen. Unter "weicher" Amplitudenbegrenzung wird dabei eine Amplitudenbegrenzung verstanden, die in Abhängigkeit von den Schwankungen des HF-Eingangssignals am Ausgang noch eine deutliche Änderung zuläßt. Es wird also lediglich der Dynamik-Umfang reduziert.

Unter "harter" Amplitudenbegrenzung versteht man eine näherungsweise konstante Ausgangsspannung in Abhängigkeit von Schwankungen des Eingangssignals.

Der Phasendetektor 2 weist beispielweise zwei nicht dargestellte Mischer auf, die das Hochfrequenzsignal in ein gepulstes Signal umwandeln, dessen Größe proportional zu SIN(phi) bzw. COS(phi) ist. Die zwei Sample & Hold-Schaltungen 4 und 4' gewinnen daraus u.a. durch Setzen eines Abtastfensters zwei Gleichspannungssignale, die proportional zu SIN(phi) und COS(phi) sind. Die Breite des Abtastfensters und seine Lage, also der Zeitpunkt der Abtastung sind frei einstellbar. Die so gewonnenen SIN(phi) und COS(phi)-Signale werden dann über eine Konverterschaltung 14, die sonst für Resolver verwendet wird, in ein (phi)-proportionales Signal von 0 bis 360° umgesetzt. Dieses von der Konverterschaltung 14 ausgegebene Phasensignal (phi) ist verzerrt und wird so in den Phasenkorrekturspeicher 8 eingegeben. Außerdem wird es über einen Rechnerbus gegebenenfalls einem Rechner zugeführt, wenn die Korrekturspeicherwerte ermittelt werden.

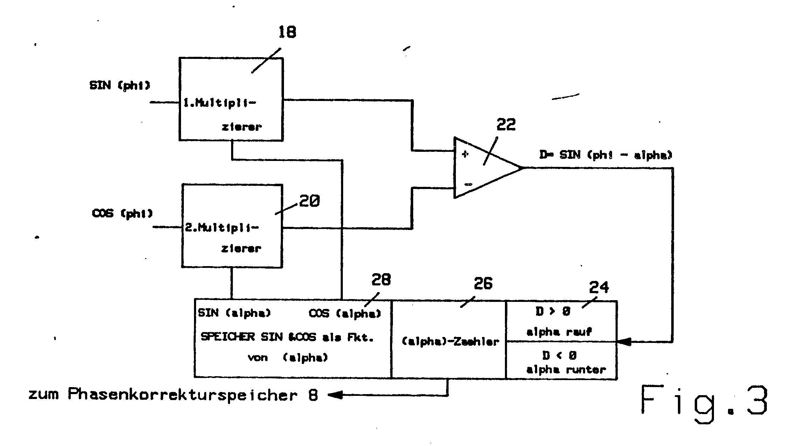

Parallel zu der Konverterschaltung 14 ist die Amplitudengewinnungsschaltung 6 an die Sample & Hold-Schaltungen 4, 4' angeschlossen und nimmt die Signale SIN(phi) und COS(phi) auf. Die Amplitudengewinnungsschaltung 6 erzeugt in anhand von Figur 3 erläuterter Weise Amplitudensignale, die wiederum wie bei dem ersten Ausführungsbeispiel dem Amplitudenkompressionsspeicher 10 eingegeben werden, der seinerseits den Phasenkorrekturspeicher 8 ansteuert. Dem Phasenkorrekturspeicher 8 ist wiederum die Anzeige 12 nachgeschaltet.

Figur 3 zeigt Einzelheiten der Amplitudengewinnungsschaltung, in der die Amplitude des Meßsignals aus der Beziehung SIN(phi)² + COS(phi)² ermittelt wird. Hierzu wird das Signal SIN(phi) einem ersten Multiplizierer 18 und das Signal COS(phi) einem zweiten Multiplizierer 20 eingegeben. Der Ausgang des ersten Multiplizierers 18 ist mit dem positiven Eingang eines Komparators 22 verbunden. Der Ausgang des zweiten Multiplizierers 20 steht mit dem negativen Eingang des Komparators 22 in Verbindung. Dem ersten Multiplizierer 18 wird ein Signal COS($\alpha$) und dem zweiten Multiplizierer 20 ein Signal SIN($\alpha$) von einem Winkelfunktionenspeicher 28 zugeführt, in dem für jeden Winkel $\alpha$ die Sinus- und Cosinusfunktion gespeichert ist. Der jeweilige Winkel ($\alpha$) wird von einem ($\alpha$)-Zähler 26 ausgewählt. Im ersten Multiplizierer 18 wird somit das Produkt SIN(phi) COS($\alpha$) und im zweiten Multiplizierer das Produkt COS(phi) SIN($\alpha$) gebildet, so daß bei einer Subtraktion der beiden Multipliziererausgaben die Differenz D = SIN(phi -$\alpha$ ) gebildet wird. Dieses Differenzsignal D wird einer Vergleicherschaltung 24 eingegeben, die den ($\alpha$)-Zähler 26 ansteuert, und zwar in der Weise, daß immer dann, wenn die Differenz D größer als Null ist, der ($\alpha$)-Zähler 26 erhöht und bei D kleiner als Null erniedrigt wird. Dies führt letzlich zu einer Differenz von Null, d.h. (phi) entspricht ($\alpha$), so daß der Zählerstand des ($\alpha$)-Zählers 26 dann als verzerrte Phase (phi) an den Phasenkorrekturspeicher 8 ausgegeben werden kann.

Es wird darauf hingewiesen, daß lediglich die Bauteile des Phasendetektors in bezug auf Temperaturschwankungen empfindlich sind, so daß es zweckmäßig ist, den Phasendetektor 2 in einem nicht dargestellten Ofen unterzubringen, der durch eine Heizung auf konstanter Temperatur gehalten werden kann. Derartig kleine Heizöfen sind allgemein bekannt und ohne weiteres erhältlich.

**Ansprüche**

1 Meßschaltung zur Phasenmessung gepulster Hochfrequenz-Signale, mit einem Phasendetektor (2), der einen Meßsignaleingang (1) und einen Referenzsignaleingang (3) aufweist und der aus der Phasendifferenz zwischen Meßsignal und Referenzsignal ein Phasendifferenzsignal erzeugt, das einer Sample & Hold-Schaltung (4) zugeführt wird, die daraus eine Gleichspannung erzeugt, **dadurch gekennzeichnet,** daß die Gleichspannung einem Phasenkorrekturspeicher (8) eingegeben wird, in dem eine Korrektur der Nichtlinearität des Phasendetektors erfolgt;

daß an den Meßsignaleingang (i) und den Referenzsignaleingang (3) eine Amplitudengewinnungsschaltung (6) angeschlossen ist, die die Amplitude des Meßsignals und des Referenzsignals ermittelt;

daß an den Ausgang der Amplitudengewinnungsschaltung (6) ein Amplitudenkompressionsspeicher (10) angeschlossen ist, der eine mit der Signalamplitude steuerbare Dichte der Kennlinienkorrekturen vornimmt; und
daß die Ausgänge der Sample & Hold-Schaltung (4) und der Amplitudenkompressionsschaltung (10) den Phasenkorrekturspeicher (8) ansteuern, der die Verzerrung der Phasenkennlinie korrigiert.

2 Schaltung nach Anspruch 1, **dadurch gekennzeichnet,** daß dem Phasendetektor (2) weiche und/oder harte Amplitudenbegrenzungsschaltungen (16, 16') zur Erweiterung des Dynamikbereichs vorgeschaltet sind.

3 Schaltung nach Anspruch 1 oder 2, **dadurch gekennzeichnet,** daß der Phasendetektor (2) ein dem Cosinus sowie dem Sinus der zu messenden Phasenverschiebung entsprechendes Signal erzeugt und daß die Amplitudengewinnungsschaltung (6) ein amplitudenabhängiges Signal durch Quadratur des Sinus- und Cosnius-Signals und Summation der beiden erzeugt.

4 Schaltung nach einem der Ansprüche 1 bis 3, **dadurch gekennzeichnet,** daß zwischen die Sample & Hold-Schaltungen (4, 4') und den Phasenkorrekturspeicher (8) eine Konverterschaltung (14) geschaltet ist, die aus den Sinus- und Cosinus-Signalen ein Phasensignal erzeugt.

5 Schaltung nach einem der Ansprüche 1 bis 4, **dadurch gekennzeichnet,** daß die den Phasendetektor (2) bildenden Bauteile in einem elektrischen Ofen untergebracht sind.

Fig.1

EP 0 325 173 A2

MESS-SIGNAL

REFE-RENZ-SIGNAL

(phi)

16 — Amplitudenbegrenzung WEICH

16' — Amplitudenbegrenzung HART

2 — PHASENDETEKTOR

Abtastfenster 4 — S&H — SIN(phi)

Abtastfenster 4' — S&H — COS(phi)

SIN(phi)

COS(phi)

14 — KONVERTERSCHALTUNG

SCHREIBBUS

Phase (phi) verzerrt

8 — Phasenkorrektur-SPEICHER

Anzeige Einheit 12

6 — Amplitude - SIN(phi)$^2$ + COS(phi)$^2$

SCHREIBBUS

10 — Amplitudenkompressions-SPEICHER

Fig.2

Fig.3

zum Phasenkorrekturspeicher 8

EP 0 325 173 A2